# EUROPEAN PATENT APPLICATION

(11) **EP 2 770 802 A1**
(43) Date of publication of application: **27.08.2014**
(21) Application number: 12847850.0
(22) Date of filing: 09.10.2012
(51) Int. Cl.: H05B 33/02, H01L 51/50, H05B 33/04, H05B 33/10, H05B 33/22

(54) **ORGANIC ELECTRO-LUMINESCENCE DEVICE AND METHOD FOR MANUFACTURING ORGANIC ELECTRO-LUMINESENCE DEVICE**

(30) Priority: 10.11.2011 JP 2011246827; 14.06.2012 JP 2012135224
(71) Applicant: Nitto Denko Corporation, Ibaraki-shi, Osaka 567-8680 (JP)
(72) Inventor: OSAKI Yoshinori, Ibaraki-shi Osaka 567-8680 (JP); NAKAI Takahiro, Ibaraki-shi Osaka 567-8680 (JP); MORITA Shigenori, Ibaraki-shi Osaka 567-8680 (JP); NAGASE Junichi, Ibaraki-shi Osaka 567-8680 (JP)
(74) Representative: HOFFMANN EITLE
(86) International application number: PCT/JP2012/076143
(87) International publication number: WO 2013/069400

(57) **Abstract**

An organic EL device and a method for forming the same, capable of obtaining a high light emission yield and improving long-term stability. The organic EL device is an organic EL device (100) including: a conductive substrate (101); an inorganic insulating layer (102) formed over the conductive substrate (101); an organic insulating layer (103) formed over the inorganic insulating layer (102); and an organic EL element (110) formed over the organic insulating layer (103); and a sealing material (150) of sealing the organic insulating layer (103) and the organic EL element (110), and the organic insulating layer (103) is formed inside the sealing material (150).

## Description

### Field of the Invention

The present invention relates to an organic EL device and a method for producing the same.

### Background of the Invention

It has been known that organic EL (electroluminescence) devices are deteriorated by moisture and oxygen in the air. Therefore, as a substrate for forming an organic EL element and a sealing plate of the organic EL element, materials with low moisture permeability, such as glass and metals, have been used. In recent years, a flexible device has been developed, and in order to make an organic EL device flexible, it has been considered that a substrate composed of an organic resin is used. However, there is a problem in that the organic EL element is prone to be deteriorated by oxygen and moisture entered thereinto by permeating through the organic resin. Therefore, it has been considered that a metal plate is used as the substrate. In this case, it is required to provide the metal plate with an insulating layer in order to produce an organic EL element. Forming an organic resin layer or an inorganic layer as the insulating layer has been proposed (e.g., see Patent Documents 1 to 3).

### Patent Documents

Patent Document 1: JP 2002-25763 A
Patent Document 2: JP 2010-82899 A
Patent Document 3: Japanese Patent No. 3942017

### Brief Summary of the Invention

Although the organic resin layer is superior in smoothness, it is inferior in moisture barrier properties. On the other hand, although the inorganic layer is favorable in moisture barrier properties compared with the organic resin layer, it is difficult to be insulated (due to generation of a pinhole) and to maintain the smoothness in the case where the inorganic layer is thin. Moreover, in the case where the inorganic layer is thick, although the smoothness is improved, there is a problem in that it is easily cracked. Furthermore, when the organic resin layer is formed, an organic resin is exposed to an end plane part and an extraction electrode part of the organic EL element, and oxygen and moisture are permeated from the exposed part through the resin, resulting in a problem of deteriorating the element.

Hence, the present invention is intended to provide an organic EL device and a method for producing the same, capable of obtaining a high light emission yield and improving long-term stability.

The organic EL device according to the present invention is an organic EL device including: a conductive substrate; an inorganic insulating layer formed over the conductive substrate; an organic insulating layer formed over the inorganic insulating layer; an organic EL element formed over the organic insulating layer; and a sealing material for sealing the organic insulating layer and the organic EL element, wherein the organic insulating layer is formed inside the sealing material.

The method for producing an organic EL device according to the present invention is a method for producing an organic EL device, including: forming an inorganic insulating layer over a conductive substrate; forming an organic insulating layer over the inorganic insulating layer; forming an organic EL element over the organic insulating layer; and forming a sealing material so as to enclose the organic insulating layer and the organic EL element, wherein forming the organic insulating layer comprises a patterning step of selectively forming the organic insulating layer.

The present invention can provide an organic EL device and a method for producing the same, capable of obtaining a high light emission yield and improving long-term stability.

### Brief Description of Drawings

FIG. 1 is a schematic cross-sectional view showing an example of the configuration of an organic EL device according to the first embodiment.
FIG. 2 is a schematic cross-sectional view showing a modified example of the configuration of an organic EL device according to the first embodiment.
FIG. 3 is a schematic cross-sectional view showing an example of the configuration of an organic EL device according to the second embodiment.
FIG. 4 is an enlarged explanatory drawing of the vicinity of a side surface part of the organic insulating layer in FIG. 3.
FIG. 5 is a schematic cross-sectional view showing a modified example of the configuration of an organic EL device according to the second embodiment.
FIG. 6 is a schematic cross-sectional view showing the configuration of organic EL devices of Comparative Examples 1 to 4.
FIG. 7 is a schematic cross-sectional view showing the configuration of organic EL devices of Comparative Examples 5 to 7.
FIG. 8 is a schematic cross-sectional view showing the configuration of organic EL devices of Comparative Examples 8 to 10.
FIG. 9 is a schematic cross-sectional view showing the configuration of organic EL devices of Comparative Examples 11 to 13.

### Detailed Description of the Invention

In the organic EL device according to the present invention, it is preferred that at least a part of the side surface of the organic insulating layer is a tapered surface of inwardly sloping from the lower side toward the upper side, and an angle formed between the tapered surface of the organic insulating layer and a plane of the conductive substrate (hereinafter also referred to as "tapered angle") is in a range from 1° to 50°.

In the organic EL device according to the present invention, it is preferred that the inorganic insulating layer contains at least one kind of a metal and a metalloid, selected from the group consisting of oxide, nitride, carbide, oxynitride, oxycarbide, carbonitride, and oxycarbonitride.

In the organic EL device according to the present invention, it is preferred that the organic insulating layer is at least one material selected from the group consisting of an acrylic resin, a norbornene resin, an epoxy resin, and a polyimide resin.

In the method for producing an organic EL device (hereinafter referred to as "organic EL device production method") according to the present invention, it is preferred that, the organic insulating layer is formed so as to have a tapered surface of inwardly sloping from a lower side toward an upper side in at least a part of a side surface of the organic insulating layer, with an angle formed between the tapered surface of the organic insulating layer and a plane of the conductive substrate in a range from 1° to 50°.

In the organic EL device production method according to the present invention, it is preferred that the patterning step is performed by photolithography.

It is preferred that organic EL devices of the other aspects of the present invention are produced by the organic EL device production method according to the present invention.

The present invention is described in detail below. The present invention, however, is not limited by the following description.

### [First embodiment]

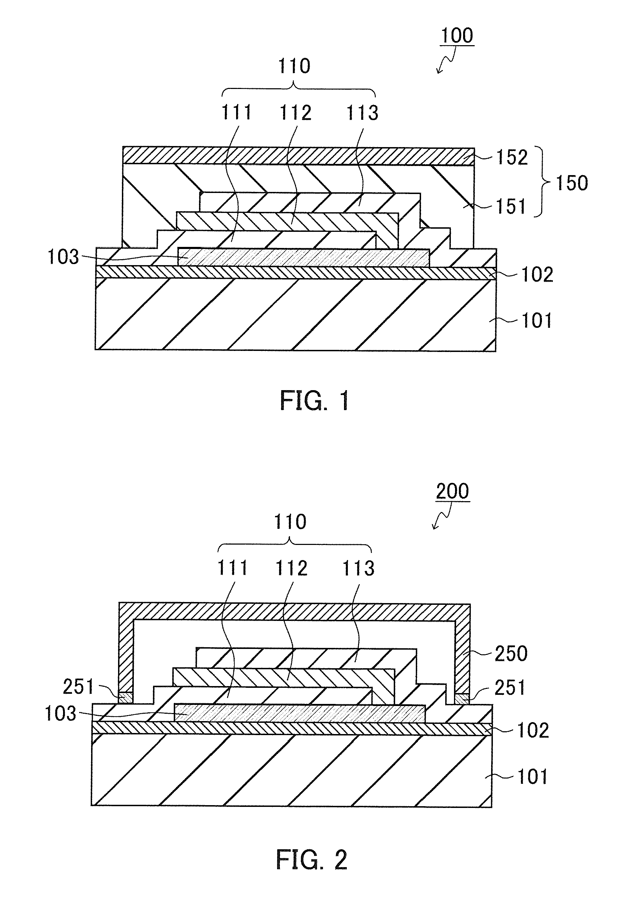

FIG. 1 is a schematic cross-sectional view showing an example of the configuration of an organic EL device according to the present embodiment. As shown in FIG. 1, in this organic EL device 100, an inorganic insulating layer 102 and an organic insulating layer 103 are formed over a conductive substrate 101 in this order, and an organic EL element 110 is on the organic insulating layer 103. The organic insulating layer 103 and the organic EL element 110 are subjected to surface-sealing using a sealing layer 151 and a sealing plate 152 as a sealing material 150. The organic insulating layer 103 on which the organic EL element 110 has been formed inside the sealing layer 151 so as not to be exposed from the sealing layer 151. In the organic EL element 110, when a current is supplied from the outside via an anode 111 and a cathode 113, an electron and a positive hole are bonded to each other in the organic EL layer 112, and then, the organic EL layer 112 emits light utilizing excitation energy generated by the bonding. In the present invention, the light emitted from the organic EL layer 112 is ejected from the cathode 113 side of the organic EL element 110 (top emission system).

The organic EL element has a laminate obtained by providing an anode, an organic EL layer, and a cathode on a substrate in this order. As the anode, a layer of ITO (Indium Tin Oxide) or IZO (registered trademark, Indium Zinc Oxide), which can be used as a transparent electrode layer is formed, for example. For example, the organic EL layer is composed of a hole injection layer, a positive hole transport layer, a luminant layer, an electron transport layer, and an electron injection layer. As the cathode, an aluminium layer, a magnesium/aluminium layer, a magnesium/silver layer, or the like, functioning also as a reflecting layer, is formed. Sealing is performed on this laminate so as not to expose the laminate to the air.

In the organic EL device according to the present invention, a conductive substrate is used as the substrate. It is required to maintain insulation properties of the surface of a conductive substrate, on which the organic EL element is formed. Therefore, in the case of using a conductive substrate, it is required to provide the conductive substrate with an insulating layer. In the present invention, an organic EL element is placed on the plane of a conductive substrate on which an inorganic insulating layer and an organic insulating layer have been laminated as an insulating layer in this order. The organic EL element is formed on the organic insulating layer. Then, the organic EL device further includes a sealing material for sealing the organic insulating layer and the organic EL element, and the organic insulating layer is formed inside the sealing material.

As the conductive substrate, stainless, iron, aluminium, nickel, cobalt, copper, or an alloy thereof can be used, for example. The metal which can be formed into a film such as a metal foil at ordinary temperature under normal pressure is preferable, and any of such metals can be used. When a metal foil is used as the substrate, the weight and the thickness of the organic EL element can be reduced, and the organic EL element can be flexible. In this case, the organic EL device as a display can be flexible. Thus, this organic EL device can be used as if it is an electronic paper which can be rolled up and the like.

The inorganic insulating layer in the present invention may be formed of an insulating material having gas barrier properties. The inorganic insulating layer preferably contains at least one kind of a metal and a metalloid. The at least one kind of a metal and a metalloid is preferably at least one kind selected from the group consisting of oxide, nitride, carbide, oxynitride, oxycarbide, carbonitride, and oxycarbonitride. Examples of the metal include zinc, aluminium, titanium, copper, and magnesium, and examples of the metalloid include silicon, bismuth, and germanium.

When the inorganic insulating layer is too thin, insulation properties are deteriorated. When the inorganic insulating layer is too thick, cracks are prone to be generated, and gas barrier properties and insulation properties are deteriorated. The thickness of the inorganic insulating layer is preferably in the range from 10 nm to 5 µm, more preferably from 50 nm to 2 µm, yet more preferably from 0.1 to 1 µm. A method for forming the inorganic insulating layer is not limited, and a dry method such as a vapor deposition method, a sputtering method, or a CVD method or a wet method such as a sol-gel method can be utilized.

In the present invention, when the inorganic insulating layer is selected from the group consisting of metal oxide, metal nitride, metalloid oxide, and metalloid nitride, oxygen or nitrogen contained in the oxide or the nitride can be introduced by vapor deposition of at least one kind of the metal and the metalloid through generation of arc-discharge plasma in the presence of a reactive gas, for example. As a vapor deposition material in the vapor deposition, metal oxide or a metalloid oxide can also be used. As the reactive gas, an oxygen-containing gas, a nitrogen-containing gas, or a mixture thereof can be used. Examples of the oxygen-containing gas include oxygen (O₂), dinitrogen monoxide (N₂O), and nitric oxide (NO), and examples of the nitrogen-containing gas include nitrogen (N₂), ammonia (NH₃), and nitric oxide (NO).

As a means for vaporizing the vapor deposition material, a method in which any of resistance heating, an electron beam, and arc-discharge plasma is introduced into the vapor deposition material (vapor deposition source) can be used. Among them, a method using an electron beam or arc-discharge plasma, capable of performing high-speed vapor deposition, is preferable. These methods can be used in combination.

As the organic insulating layer in the present invention, an insulating resin layer can be used. The conductive substrate may be heated at 150°C to 300°C from the viewpoint of a production process. Thus, it is preferred that a heat-resistant resin with a glass-transition temperature of 150°C or more is selected as the resin. Specific examples thereof include an acrylic resin, a norbornene resin, an epoxy resin, a polyimide resin, a polyamideimide resin, a polyamide resin, a polyester resin, a polyarylate resin, a polyurethane resin, a polycarbonate resin, a polyether ketone resin, and a polyphenylsulfone resin, and complexes thereof. Among them, the resin is preferably at least one material selected from the group consisting of an acrylic resin, a norbornene resin, an epoxy resin, and a polyimide resin.

When the organic insulating layer is too thin, the uneven surface of the conductive substrate cannot be flattened sufficiently. When the thickness is too thick, the adhesion to the inorganic insulating layer and the organic EL element may be reduced. Thus, the thickness of the organic insulating layer is preferably in the range from 1 to 40 µm or from 0.5 to 40 µm. When the thickness is in the above-described range, sufficient electric insulation properties can be maintained, and the adhesion to the base can also be maintained. The thickness of the organic insulating layer is more preferably in the range from 1 to 10 µm or from 0.5 to 10 µm, yet more preferably from 1 to 5 µm. In the above-described range, there is a more preferable range of the thickness of the organic insulating layer according to the size of the uneven surface of the conductive substrate. A method for forming the organic insulating layer is not limited, and the organic insulating layer can be formed by application using roll coating, spray coating, spin coating, dip coating, or the like or transfer of a rain formed into a film.

In the present invention, the organic insulating layer can be selectively formed in a region in which the organic EL element is formed by a patterning step. As a method for the patterning, photolithography, photo etching, a screen printing method, an ink-jet printing method, or the like can be used. The patterning is preferably performed by photolithography. The photolithography has high pattern accuracy and can easily perform microfabrication. Moreover, as mentioned below, when each of the side surfaces of the organic insulating layer is formed into a tapered surface of inwardly sloping from the lower side toward the upper side, the taper angle can be easily adjusted by adjusting the amount of exposure to light in the photolithography, conditions of the post-baking, and the like.

As the sealing layer, a material which is superior in durability and heat resistance and has low water permeability can be used. Examples of such material include an epoxy resin, an acrylic resin, a polyester resin, a polyarylate resin, and a polyurethane resin. Using a two-component curable epoxy resin is preferable because it is possible to cure at ordinary temperature, and it is not required to heat the organic EL element, and thus, the sealing layer is prevented from being deteriorated. As the sealing plate, a material with low water permeability, such as a glass plate, a resin film on which a gas barrier layer has been formed, or the like is preferable.

According to the present embodiment, the sealing material is formed inside the sealing material so as not to expose from the sealing material. Thus, a high light emission yield can be obtained, and long-term stability can be improved.

FIG. 2 is a schematic cross-sectional view showing a modified example of the configuration of an organic EL device according to the present embodiment. In FIG. 2, similar parts to those shown in FIG. 1 are denoted by identical reference numerals. In this organic EL device 200, a glass cap is used as a sealing material 250, and the periphery of the glass cap is hollow-sealed using an adhesive 251. An organic insulating layer 103 on which an organic EL element 110 has been formed inside the sealing material 250 (glass cap) so as not to expose from the sealing material 250. As the adhesive 251 for use in the sealing, the same material as in the above-mentioned sealing layer 151 can be used.

### [Second embodiment]

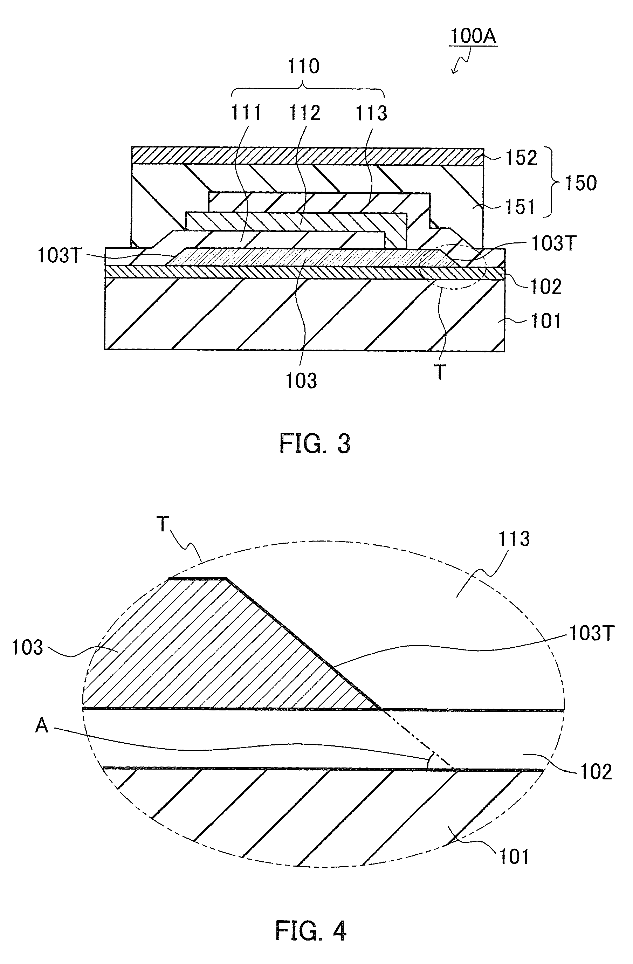

FIG. 3 is a schematic cross-sectional view of an example of the configuration of an organic EL device according to the present embodiment. In FIG. 3, similar parts to those in FIG. 1 are denoted by identical reference numerals. In this organic EL device 100A, each of the side surfaces of an organic insulating layer 103 is formed into a tapered surface 103T of inwardly sloping from the lower side toward the upper side. It is preferred that each tapered surface 103T forms an angle with the plane of the conductive substrate 101 in the range from 1° to 50°. FIG. 4 is an enlarged explanatory drawing of the vicinity of a side surface (region T of FIG. 3) of the organic insulating layer 103. The angle indicates an angle (angle A in FIG. 4) at a part of crossing an extended cross-sectional line of the side surface of the organic insulating layer 103 with the plane of the conductive substrate 101. When the angle is more than 50°, a disconnection of an electrode (an anode 111 or a cathode 113) in the organic EL element is prone to occur due to the sloping of the organic insulating layer. Moreover, the angle of less than 1° causes an increase in width of each tapered surface, an increase in length of the extraction electrode, and a decrease in area of a light-emitting part and thus is not preferable. The angle is preferably in the range from 10° to 40°, more preferably from 10° to 20°. When an anode or a cathode is not formed in the end part of the organic insulating layer, the tapered surface is not necessary to be provided. As described above, when each side surface of the organic insulating layer 103 is configured to be a tapered surface 103T with a taper angle in the range from 1° to 50°, the anode 111 and the cathode 113 in the organic EL element 110 can be prevented from being disconnected. Each side surface of the organic insulating layer can be formed into a tapered surface inwardly sloping from the lower side toward the upper side by using photolithography in formation of the organic insulating layer and adjusting the amount of exposure to light, conditions of post-baking, and the like, for example.

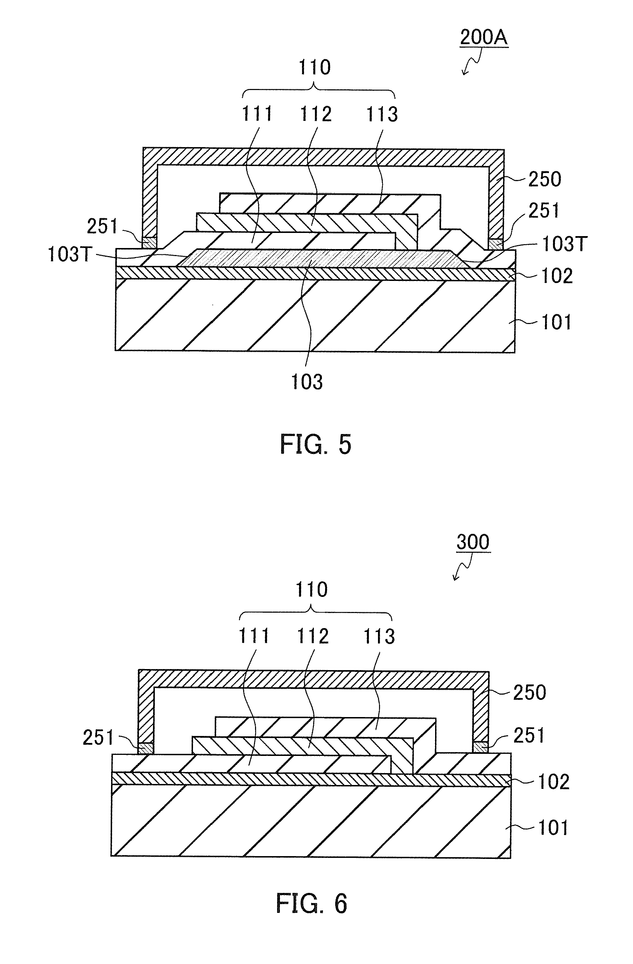

FIG. 5 is a schematic cross-sectional view showing a modified example of the configuration of an organic EL device according to the present embodiment. In FIG. 5, similar parts to those in FIGs. 1 to 3 are denoted by identical reference numerals. As in the organic EL device 100A, in this organic EL device 200A, at least a part of each side surface of an organic insulating layer 103 is a tapered surface 103T of inwardly sloping from the lower side toward the upper side. The other configuration is the same as the organic EL device 200 shown in FIG. 2, and a glass cap is used as a sealing material 250, and the periphery of the glass cap is sealed using an adhesive 251, which forms hollow area.

According to the present embodiment, the same effect as in the first embodiment can be obtained. Moreover, since each side surface of the organic insulating layer has the above-described taper angle, a disconnection of each electrode in the organic EL element due to the sloping of the organic insulating layer is less prone to occur, and an area of a light-emitting part can be widened.

### Examples

The examples of the present invention are described below together with the comparative examples. The present invention, however, is not at all limited by the following examples and comparative examples. Various characteristics and physical properties in the examples and the comparative examples were measured and evaluated by the following methods.

### (Thicknesses of inorganic insulating layer and organic insulating layer)

The thickness of each of an inorganic insulating layer and an organic insulating layer was determined by observing the cross section of an organic EL device with a scanning electron microscope (trade name: JSM-6610) manufactured by Nihon Denshi Co. Ltd. and measuring the length of each layer.

### (Light emission yield)

20 organic EL devices each having a 2-mm-square light-emitting part were produced, and initial light-emitting states were observed with an optical microscope (digital microscope manufactured by Keyence Corporation (trade name: VHX-1000)). The number of elements in the favorable light-emitting state was counted, and a light emission yield was calculated.

### (Light emission area)

The organic EL devices were stored under constant temperature and humidity conditions at a temperature of 60°C and a humidity of 90% RH in the state of not lighting. After 200 hours of storage, the organic EL devices were caused to emit light, and each light emission area was measured by observation with a microscope. In the observation and the measurement of the light emission area, a digital microscope manufactured by Keyence Corporation (trade name: VHX-1000) was used.

### (Taper angle in side surface of organic insulating layer)

The taper angle in each side surface of each organic insulating layer was measured by observing the cross section of each organic EL device with a scanning electron microscope (trade name: JSM-6610) manufactured by Jeol Ltd.

### [Example 1]

### [Production of insulating layer]

As a conductive substrate for use in production of an organic EL element, a stainless (SUS) substrate was provided (SUS304, thickness: 50 µm). A SiO₂ layer (inorganic insulating layer, thickness: 0.3 µm) was formed on the SUS substrate by sputtering. Then, a norbornene resin (manufactured by Zeon Corporation, trade name: "ZEOCOAT") was applied on the SiO₂ layer with a wire bar, and a resultant laminate was pre-baked at 100°C for 5 minutes. Thereafter, the norbornene resin layer was patterned by photolithography so that the norbornene resin layer was not exposed to the outside after being sealed with a sealing material. The photolithography was performed by exposure to light in a predetermined pattern, using an aqueous TMAH (tetramethylammonium hydroxide) solution as a developer. The patterned norbornene resin layer was post-baked at 220°C for 1 hour. Thus, an organic insulating layer with a patterned thickness of 3 µm was obtained. Thereafter, the organic insulating layer was subjected to a step of washing with pure water and then a step of heating at 200°C for 1 hour. Each of the side surfaces of the organic insulating layer was a tapered surface of inwardly sloping from the lower side toward the upper side, and the tapered angle was about 20°.

### [Production of organic EL element]

On the obtained insulating layer, Al with a thickness of 100 nm as an anode, HAT-CN (1,4,5,8,9,12-hexaazatriphenylenehexacarbonitrile) with a thickness of 10 nm as a hole injection layer, NPB (N,N'-bis(naphthalene-1-yl)-N,N'-bis(phenyl)-benzidine) with a thickness of 50 nm as a hole transport layer, Alq (tris(8-quinolinolato)aluminium) with a thickness of 45 nm as a luminant layer and an electron transport layer, LiF with a thickness of 0.5 nm as an electron injection layer, Mg/Ag with a thickness of 5/15 nm (co-vapor deposition) as a cathode, and MoO₃ with a thickness of 60 nm as a reflection adjustment layer were vapor-deposited in this order by a vacuum vapor deposition method. Thus, an organic EL element was produced.

### [Sealing]

After forming the organic EL element, sealing was performed by providing the organic EL element with a glass cap so as to be connectable from the anode and the cathode with a terminal in the state of covering the luminant layer (see FIG. 2). Thus, an organic EL device of the present example was obtained. The glass cap was sealed by applying an adhesive containing a two-component curable epoxy resin (manufactured by Konishi Co., Ltd., trade name: "Bond Quick 5") to the vicinity of the glass cap and curing the adhesive by natural air.

### [Example 2]

An organic EL device of the present example was obtained in the same manner as in Example 1 except that an epoxy resin with the following composition was used as substitute for the norbornene resin. The epoxy resin was applied with a wire bar, and a resultant laminate was pre-baked at 90°C for 15 minutes. The photolithography was performed by exposure to light in a predetermined pattern, using acetonitrile as a developer. The patterned epoxy resin layer was post-based at 170°C for 30 minutes. Thus, an organic insulating layer with a patterned thickness of 3 µm was obtained. Each of the side surfaces of the organic insulating layer was a tapered surface of inwardly sloping from the lower side toward the upper side, and the tapered angle was about 50°.

### (Epoxy resin)

Florene derivative 1: 50 parts by weight
Florene derivative 2: 50 parts by weight
Photoacid generator: 1 parts by weight

Florene derivative 1: bisphenoxy ethanol fluorene diglycidyl ether
   (in the following general formula (1), R₁ to R₆ are all hydrogen atoms, and both n = 1)
Florene derivative 2: bisphenol fluorene diglycidyl ether
   (in the following general formula (1), R₁ to R₆ are all hydrogen atoms, and both n = 0)
Photoacid generator: 50% solution of
   4,4-bis[di(ß-hydroxyethoxy)phenylsulfonio]phenyl
   sulfide-bis-hexafluoroantimonate in propion carbide

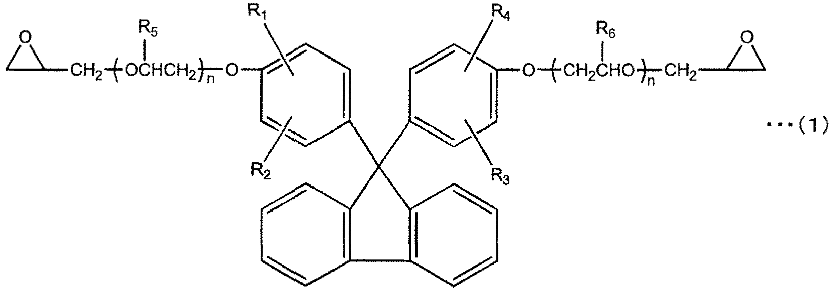

### [Example 3]

An organic EL device of the present example was obtained in the same manner as in Example 1 except that an acrylic resin (manufactured by JSR Corporation, trade name: "JEM-477") was used as substitute for the norbornene resin. The acrylic resin was applied with a wire bar, and a resultant laminate was pre-baked at 100°C for 5 minutes. The photolithography was performed by exposure to light in a predetermined pattern, using an aqueous TMAH solution as a developer. The patterned acrylic resin layer was post-based at 220°C for 1 hour. Thus, an organic insulating layer with a patterned thickness of 3 µm was obtained. Each of the side surfaces of the organic insulating layer was a tapered surface of inwardly sloping from the lower side toward the upper side, and the tapered angle was about 10°.

### [Example 4]

An organic EL device of the present example was obtained in the same manner as in Example 3 except that the patterned acrylic resin layer was post-baked at 200°C for 1 hour. Each of the side surfaces of the organic insulating layer was a tapered surface of inwardly sloping from the lower side toward the upper side, and the taper angle was about 20°.

### [Example 5]

An organic EL device of the present example was obtained in the same manner as in Example 3 except that the patterned acrylic resin layer was post-baked at 180°C for 1 hour. Each of the side surfaces of the organic insulating layer was a tapered surface of inwardly sloping from the lower side toward the upper side, and the taper angle was about 40°.

### [Example 6]

An organic EL device of the present example was obtained in the same manner as in Example 3 except that the patterned acrylic resin layer was post-baked at 160°C for 1 hour. Each of the side surfaces of the organic insulating layer was a tapered surface of inwardly sloping from the lower side toward the upper side, and the taper angle was about 50°.

### [Example 7]

An organic EL device of the present example was obtained in the same manner as in Example 3 except that the patterned acrylic resin layer was post-baked at 150°C for 1 hour. Each of the side surfaces of the organic insulating layer was a tapered surface of inwardly sloping from the lower side toward the upper side, and the taper angle was about 60°.

### [Comparative Examples 1 to 4]

FIG. 6 shows a schematic cross-sectional view of the configuration of organic EL devices 300 of Comparative Examples 1 to 4. Comparative Examples 1 to 4 show an example of forming no organic insulating layer and including only an inorganic insulating layer 102 as an insulating layer.

### [Comparative Example 1]

An organic EL device of the present comparative example was obtained in the same manner as in Example 1 except that an organic insulating layer was not formed.

### [Comparative Example 2]

An organic EL device of the present comparative example was obtained in the same manner as in Comparative Example 1 except that the thickness of a SiO₂ layer (inorganic insulating layer) formed by sputtering was set to 0.1 µm.

### [Comparative Example 3]

An organic EL device of the present comparative example was obtained in the same manner as in Comparative Example 1 except that the thickness of a SiO₂ layer (inorganic insulating layer) formed by sputtering was set to 0.5 µm.

### [Comparative Example 4]

An organic EL device of the present comparative example was obtained in the same manner as in Comparative Example 1 except that the thickness of a SiO₂ layer (inorganic insulating layer) formed by sputtering was set to 1 µm.

### [Comparative Examples 5 to 7]

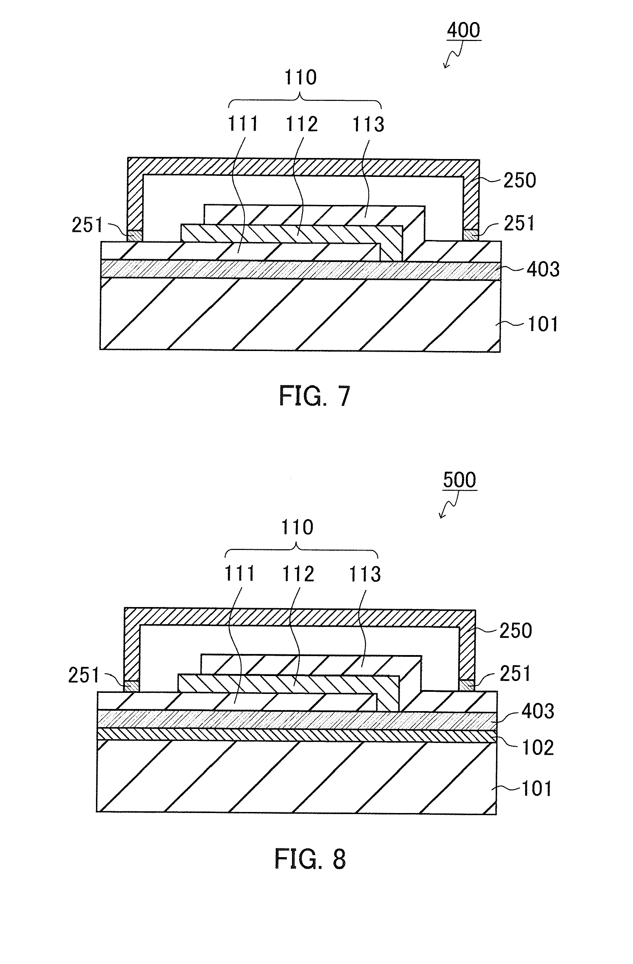

FIG. 7 shows a schematic cross-sectional view of the configuration of organic EL devices 400 of Comparative Examples 5 to 7. Comparative Examples 5 to 7 show an example of forming no inorganic insulating layer, patterning no organic insulating layer 403, and exposing an organic insulating layer 403 to the outside of a sealing material 250.

### [Comparative Example 5]

An organic EL device of the present comparative examples was obtained in the same manner as in Example 1 except that an inorganic insulating layer was not formed, and a norbornene resin layer was not patterned.

### [Comparative Example 6]

An organic EL device of the present comparative example was obtained in the same manner as in Example 2 except that an inorganic insulating layer was not formed, and an epoxy resin layer was not patterned.

### [Comparative Example 7]

An organic EL device of the present comparative example was obtained in the same manner as in Example 3 except that an inorganic insulating layer was not formed, and an acrylic resin layer was not patterned.

### [Comparative Examples 8 to 10]

FIG. 8 shows a schematic cross-sectional view of the configuration of organic EL devices 500 of Comparative Examples 8 to 10. Comparative Examples 8 to 10 show an example of patterning no organic insulating layer 403 and exposing an organic insulating layer 403 to the outside of a sealing material 250.

### [Comparative Example 8]

An organic EL device of the present comparative example was obtained in the same manner as in Example 1 except that a norbornene resin layer was not patterned.

### [Comparative Example 9]

An organic EL device of the present comparative example was obtained in the same manner as in Example 2 except that an epoxy resin layer was not patterned.

### [Comparative Example 10]

An organic EL device of the present comparative example was obtained in the same manner as in Example 3 except that an acrylic resin layer was not patterned.

### [Comparative Examples 11 to 13]

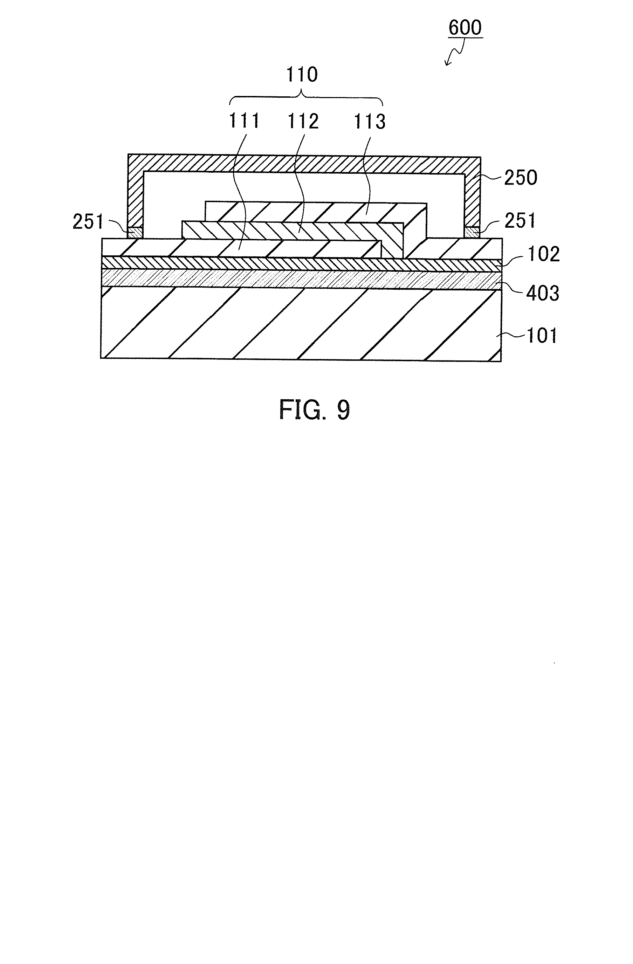

FIG. 9 shows a schematic cross-sectional view of the configuration of organic EL devices 600 of Comparative Examples 11 to 13. Comparative Examples 11 to 13 show an example of forming, over a conductive substrate 101, an organic insulating layer 403 and an inorganic insulating layer 102 which have not been patterned in this order.

### [Comparative Example 11]

An organic EL device of the present comparative example was obtained in the same manner as in Example 1 except for the following procedure. A norbornene resin (manufactured by Zeon Corporation, trade name: "ZEOCOAT") was applied on a SUS substrate with a wire bar, and a resultant laminate was dried at 100°C for 5 minutes and cured at 220°C for 1 hour. Thus, an organic insulating layer with a thickness of 3 µm was obtained. Then, an SiO₂ layer (inorganic insulating layer, with a thickness of 2 µm) was formed by sputtering. Thereafter, the step of washing with pure water and the step of heating at 200°C for 1 hour were performed.

### [Comparative Example 12]

An organic EL device of the present comparative example was obtained in the same manner as in Comparative Example 11 except that the same epoxy resin as used in Example 2 was used as substitute for the norbornene resin, the epoxy resin was applied with a wire bar, and a resultant laminate was dried at 90°C for 15 minutes, irradiated with ultraviolet light, and cured at 170°C for 30 minutes, and thus an organic insulating layer with a thickness of 3 µm was obtained.

### [Comparative Example 13]

An organic EL device of the present comparative example was obtained in the same manner as in Comparative Example 11 except that an acrylic resin (manufactured by JSR Corporation, trade name: "JEM-477") was used as substitute for the norbornene resin, the acrylic resin was applied with a wire bar, and a resultant laminate was dried at 100°C for 5 minutes and cured at 220°C for 1 hour, and thus an organic insulating layer with a thickness of 3 µm was obtained.

The light emission yield and the light emission area of each of the organic EL devices of Examples 1 to 7 and Comparative Examples 1 to 13 were measured. Table 1 shows the results of the measurements.

**[Table 1]**

| | Insulating layer configuration | | Taper angle (°) | Light emission yield (%) | Light emission area (after 200 hr) (%) |
|---|---|---|---|---|---|
| | Insulating layer 1 on SUS substrate | Insulating layer 2 on insulating layer 1 | | | |
| Ex. 1 | SiO₂ | Norbornene resin (patterned) | 20 | 100 | 100 |
| Ex. 2 | SiO₂ | Epoxy resin (patterned) | 50 | 100 | 100 |
| Ex. 3 | SiO₂ | Acrylic resin (patterned) | 10 | 100 | 95 |
| Ex. 4 | SiO₂ | Acrylic resin (patterned) | 20 | 100 | 95 |
| Ex. 5 | SiO₂ | Acrylic resin (patterned) | 40 | 100 | 95 |
| Ex. 6 | SiO₂ | Acrylic resin (patterned) | 50 | 100 | 90 |
| Ex. 7 | SiO₂ | Acrylic resin (patterned) | 60 | 90 | 90 |
| Comp. Ex. 1 | SiO₂ | - | - | 50 | 80 |
| Comp. Ex. 2 | SiO₂ | - | - | 20 | 70 |
| Comp. Ex. 3 | SiO₂ | - | - | 50 | 80 |
| Comp. Ex. 4 | SiO₂ | - | - | 10 | 80 |
| Comp. Ex. 5 | Norbornene resin | - | - | 100 | 30 |
| Comp. Ex. 6 | Epoxy resin | - | - | 100 | 30 |
| Comp. Ex. 7 | Acrylic resin | - | - | 100 | 25 |
| Comp. Ex. 8 | SiO₂ | Norbornene resin | - | 100 | 30 |
| Comp. Ex. 9 | SiO₂ | Epoxy resin | - | 100 | 30 |
| Comp. Ex. 10 | SiO₂ | Acrylic resin | - | 100 | 25 |
| Comp. Ex. 11 | Norbornene resin | SiO₂ | - | 70 | 70 |
| Comp. Ex. 12 | Epoxy resin | SiO₂ | - | 75 | 70 |
| Comp. Ex. 13 | Acrylic resin | SiO₂ | - | 75 | 65 |

As shown in Table 1, in all of the organic EL devices obtained in Examples 1 to 6, the light emission yield was 100%, and the light emission area after 200 hours of storage was 90% or more. The results of Examples 1 to 6 showed that organic EL devices each having high initial reliability and favorable deterioration preventive characteristics could be obtained. In contrast, in each of Comparative Examples 1 to 4 having no organic insulating layer, the light emission yield was 50% or less due to a short circuit of the organic EL element which may be caused by unevenness of the SUS substrate, an insulation failure between the SUS substrate and the organic EL element, and a crack in the inorganic insulating layer. In Comparative Example 1, about one-fourth of the organic EL devices established short circuits in the organic EL elements which may be caused by unevenness of the SUS substrates, and cracks were generated in inorganic insulating layers of about one-fourth of the organic EL devices. In each of Comparative Examples 5 to 7 of forming no inorganic insulating layer, patterning no organic insulating layer, and exposing the organic insulating layer to the outside of the sealing material (sealing layer) and Comparative Examples 8 to 10 of patterning no organic insulating layer formed on the inorganic insulating layer and exposing the organic insulating layer to the outside of the sealing material (sealing layer), although the light emission yield was 100%, the light emission area after 200 hours of storage was 25% to 30%. The results of Comparative Examples 5 to 10 showed that the organic EL elements were deteriorated over time. This could be considered that the organic EL elements were deteriorated by permeating oxygen and moisture into a resin which forms the organic insulating layer from a part of the organic insulating layer, exposing to the outside of the sealing layer. In each of Comparative Examples 11 to 13 of forming, over the conductive substrate, the organic insulating layer and the inorganic insulating layer in this order, cracks were generated in inorganic insulating layers of about one-fourth of the organic EL devices, and the light emission yield was 70% to 75% which was reduced. The results of Comparative Examples 11 to 13 showed that the light emission area after 200 hours of storage was 65% to 70%, and the organic EL elements were deteriorated over time. This could be considered that the organic EL elements were deteriorated by permeating oxygen and moisture into a resin which forms the organic insulating layer from a part of each organic insulating layer, exposing to the outside of each sealing layer and permeating the oxygen and the moisture into a crack in each inorganic insulating layer. The comparison between the examples and the comparative examples shows that a high initial light emission yield can be obtained, and the organic EL element can be prevented from being deteriorated over time with the configuration of the present invention.

The organic EL devices obtained in Examples 1 to 6 among Examples 1 to 7 showed that although the taper angles differ from each other, and the light emission yield was high, disconnections of the anode and the cathode in the organic EL element did not occur. On the other hand, in Example 7 with the taper angle of 60°, although the light emission area after 200 hours of storage was 90% which showed favorable characteristics of preventing deterioration, the anode and the cathode were disconnected due to the sloping of the organic insulating layer, and 2 devices among 20 devices did not emit light. Example 7 showed that although the initial light emission yield was 90% which was favorable, a higher light emission yield could be obtained by setting an angle formed between the tapered surface of the organic insulating layer and the plane of the conductive substrate in the range from 1° to 50°.

According to the organic EL device of the present invention, a high light emission yield can be obtained, and long-term stability can be improved. In the organic EL device of the present invention, a conductive base such as a metal foil for a flexible device can be used as a substrate and thus can be used in various fields of a lighting device, a display, and the like, and the use thereof is not limited.

### Explanation of reference numerals

- 100, 100A, 200, 200A, 300, 400, 500, 600: organic EL (electroluminescence) device
- 101: conductive substrate
- 102: inorganic insulating layer
- 103, 403: organic insulating layer
- 103T: tapered surface
- 110: organic EL (electroluminescence) element
- 111: anode
- 112: organic EL (electroluminescence) layer
- 113: cathode
- 150: sealing material
- 151: sealing layer
- 152: sealing plate
- 250: sealing material (glass cap)
- 251: adhesive

## Claims

1. An organic EL device comprising:
a conductive substrate;
an inorganic insulating layer formed over the conductive substrate;
an organic insulating layer formed over the inorganic insulating layer;
an organic EL element formed over the organic insulating layer; and
a sealing material for sealing the organic insulating layer and the organic EL element, wherein
the organic insulating layer is formed inside the sealing material.

2. The organic EL device according to claim 1, wherein
at least a part of a side surface of the organic insulating layer is a tapered surface of inwardly sloping from a lower side toward an upper side, and
an angle formed between the tapered surface of the organic insulating layer and a plane of the conductive substrate is in a range from 1° to 50°.

3. The organic EL device according to claim 1 or 2, wherein
the inorganic insulating layer includes at least one kind of a metal and a metalloid, selected from the group consisting of oxide, nitride, carbide, oxynitride, oxycarbide, carbonitride, and oxycarbonitride.

4. The organic EL device according to any one of claims 1 to 3, wherein
the organic insulating layer is at least one material selected from the group consisting of an acrylic resin, a norbornene resin, an epoxy resin, and a polyimide resin.

5. A method for producing an organic EL device, comprising:
forming an inorganic insulating layer over a conductive substrate;
forming an organic insulating layer over the inorganic insulating layer;
forming an organic EL element over the organic insulating layer; and
forming a sealing material so as to enclose the organic insulating layer and the organic EL element, wherein
forming the organic insulating layer forming step comprises a patterning step of selectively forming the organic insulating layer.

6. The method according to claim 5, wherein
the organic insulating layer is formed so as to have a tapered surface of inwardly sloping from a lower side toward an upper side in at least a part of a side surface of the organic insulating layer, with an angle formed between the tapered surface of the organic insulating layer and a plane of the conductive substrate in a range from 1° to 50°.

7. The method according to claim 5 or 6, wherein
the patterning step is performed by photolithography.
